# EUROPEAN PATENT APPLICATION

(11) **EP 4 822 986 A1**
(43) Date of publication of application: **14.10.2026**
(21) Application number: 26166329.8
(22) Date of filing: 20.03.2026
(51) Int. Cl.: H03F 1/02, H03F 3/187, H03F 3/21

(54) **AUDIO ENVELOPE TRACKING FOR CONTROLLING A TRACKING POWER SUPPLY**

(30) Priority: 07.04.2025 US 202519172251
(71) Applicant: Harman Becker Automotive Systems, Inc., Novi, MI 48377 (US)
(72) Inventor: HUMPHREY, Stephen, Novi, MI, 48377 (US)
(74) Representative: Westphal, Mussgnug & Partner, Patentanwälte mbB

(57) **Abstract**

Various embodiments disclose techniques for powering one or more audio output devices in an audio system. The techniques include receiving, by a processing unit within an amplifier, an audio signal from a head unit, identifying an audio envelope associated with the audio signal, and determining a first peak voltage level for a given time period based on that audio envelope. The processing unit then generates a tracking power supply control signal based on the first peak voltage level, thereby instructing a tracking power supply to provide a dynamically adjustable rail voltage to the amplifier. By regulating the rail voltage according to the amplitude of the audio signal, the amplifier efficiently delivers sufficient power to the audio output devices while minimizing distortion and optimizing energy consumption.

## Description

### BACKGROUND

### Field of the Various Embodiments

Embodiments of the present disclosure relate generally to audio systems and more specifically to audio envelope tracking for controlling a tracking power supply.

### Description of the Related Art

Current audio systems, such as audio systems in a vehicle, utilize digital signal processors (DSPs) to perform audio processing tasks such as filtering and shaping audio signals. An important aspect of audio systems is effective power management to reduce power consumption and/or heat generation. In some audio systems, a tracking power supply (TPS) control is utilized to provide dynamic output voltage adjustment based on a tracking control signal to provide efficient amplification of audio signals. Traditional approaches to implement TPS control rely on a DSP subsystem to perform tasks such as audio envelope tracking and voltage rail management. To perform TPS control, a voltage rail is determined by the audio system. The voltage rail is dynamically adjusted based upon the voltage needs of the audio system in real time based upon an input audio signal. The DSP subsystem is often provided by a centralized high-power computer (HPC). In an automotive context, a HPC is the head unit or the electronic control unit (ECU).

Traditional TPS control implementations utilize a DSP subsystem of a HPC because the HPC is often equipped with sufficient processing resources to perform computationally intensive algorithms, which can include audio envelope tracking algorithms that are used to perform TPS control. In some designs, a DSP module handles additional real-time tasks, such as dynamic audio filtering or audio mixing, thereby utilizing the same processing resources for multiple tasks.

One drawback of traditional TPS implementations is that TPS control is typically performed using the DSP subsystem and/or other processing resources of a HPC, leading to increased power consumption by the HPC and potential integration challenges. The integration challenges include the configuration in which the HPC needs information about the voltage requirements of downstream amplifiers in the audio system. Additionally, downstream components within the audio system, such as amplifiers and speakers, often lack the processing resources or a DSP subsystem to perform computations required by traditional audio envelope tracking algorithms used in many TPS control systems.

As the foregoing illustrates, what is needed in the art are more efficient techniques for performing TPS control in resource-constrained systems.

### SUMMARY

Various embodiments disclose a method and system for dynamic power management in audio systems by implementing TPS control within amplifiers. The computer implemented method includes receiving audio signals, delaying the audio signal to accommodate TPS adjustments, and dynamically providing and adjusting the TPS voltage based on the audio signal's envelope. Each amplifier or group of amplifiers operates independently to optimize power efficiency and minimize energy waste.

Further embodiments provide, among other things, one or more non-transitory computer-readable media and systems configured to execute the methods set forth above.

At least one technical advantage of the disclosed techniques relative to the prior art is that, with the disclosed techniques, TPS control can be integrated into one or more amplifiers of an audio system, rather than relying on separate HPC. By implementing TPS control within one or more of the amplifiers of an audio system, the amplifiers can dynamically adjust voltage rails utilized by the system to increase power efficiency in real time resulting in lower overall energy consumption compared to prior art approaches. Additionally, by implementing TPS control within the amplifiers, the disclosed techniques enable the amplifiers to dynamically adjust voltage rails based solely on the incoming digital audio signal, which removes the need to configure the head unit or HPC with detailed information about downstream voltage requirements. As a result, the disclosed techniques reduce computational demands for performing TPS control. These technical advantages provide one or more technological improvements over prior art approaches.

### BRIEF DESCRIPTION OF THE DRAWINGS

So that the manner in which the above recited features of the various embodiments can be understood in detail, a more particular description of the inventive concepts, briefly summarized above, may be had by reference to various embodiments, some of which are illustrated in the appended drawings. It is to be noted, however, that the appended drawings illustrate only typical embodiments of the inventive concepts and are therefore not to be considered limiting of scope in any way, and that there are other equally effective embodiments.
Figure 1 illustrates a schematic diagram of an audio system configured to implement one or more aspects of the various embodiments;
Figure 2 illustrates an example of an audio waveform, according to various embodiments;
Figure 3 illustrate examples of an audio waveform illustrating the envelope-tracking technique, according to various embodiments;
Figure 4 illustrate examples of an audio waveform illustrating the envelope-tracking technique, according to various embodiments;
Figures 5 illustrate examples of an audio waveform illustrating the envelope-tracking technique, according to various embodiments;
Figure 6 illustrates an example of an envelope-tracking implementation for a full audio waveform, according to various embodiments; and
Figure 7 illustrates a flow diagram of method steps for powering audio devices, according to various embodiments.
Figure 8 illustrates a flow diagram of method steps for generating a tracking power supply control signal based on a peak voltage level, according to various embodiments.

### DETAILED DESCRIPTION

In the following description, numerous specific details are set forth to provide a more thorough understanding of various embodiments. However, it will be apparent to those skilled in the art that the inventive concepts may be practiced without some or all of these specific details.

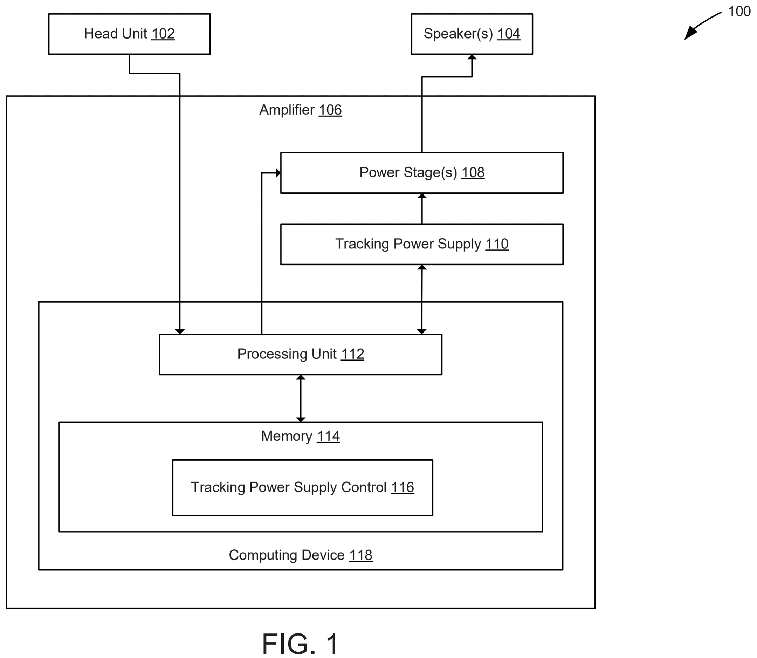

Figure 1 illustrates a schematic diagram of an audio system 100 according to various embodiments. As shown, the audio system 100 includes, without limitation, one or more head units 102, one or more speakers 104, and an amplifier 106. The amplifier 106 includes, without limitation, a computing device 118, a power stage 108, and a tracking power supply 110. The computing device 118 includes, without limitation, a processing unit 112 coupled to a memory 114 that stores instructions and data implementing a tracking power supply control 116.

The one or more head units 102 include, without limitation, any technically feasible device or component capable of providing audio signals to the amplifier 106 based on an audio source that is being played back by the audio system 100. For example, each of the one or more head units 102 includes a media player that accesses terrestrial or satellite radio, a streaming service accessed via a network connection, a local media stream (e.g., from a cellular or smart telephone), or a storage device containing music, movie soundtracks, spoken word content, or other audio files. In some embodiments, the one or more head units 102 can adapt or switch audio content based on user preferences, sensor input, system configurations, and/or the like. Once the one or more head units 102 have selected or generated the desired audio signal, the amplifier 106 receives the audio signal, processes audio signal in the computing device 118, and drives one or more speaker(s) 104 through the power stage 108 in conjunction with the tracking power supply 110.

The speaker 104 represents one or more loudspeakers or other output devices that convert the amplified audio output signal from the amplifier 106 into audible sound and/or tactile feedback for one or more listeners. Speakers 104 can be located or oriented in different configurations including in headrests, door panels, or custom enclosures. By receiving an audio signal from the dynamically adjusted rail voltage supplied through the tracking power supply 110 and the power stage 108, speakers 104 operate across varying power demands. The selection of speaker types and configurations can further depend on targeted frequency ranges, power level requirements, or user preferences.

The amplifier 106 includes, without limitation, a computing device 118, one or more power stages 108, and a tracking power supply 110. In various embodiments, the amplifier 106 can include any type of audio amplification device capable of receiving input from head unit 102 and driving the speakers 104 at a suitable power level. The amplifier 106 can be integrated into a head unit, housed as a separate standalone module, or combined with additional audio processing components depending on system requirements or design considerations. In certain configurations, the amplifier 106 is implemented as an extension amplifier with relatively low processing resources, or as a smart amplifier incorporating relatively extensive processing resources.

The power stage 108 includes one or more high-current amplifier circuit that provides amplification for the audio signals processed within the amplifier 106. In some implementations, the power stage 108 consists of one or more integrated power amplifier circuits, separate amplifying electronic components, or a combination thereof, depending on performance, cost, or design constraints. The power stage 108 receives a dynamically adjustable rail voltage from the tracking power supply 110 that allows the power stage 108 to operate at the voltage level needed at a given time based on the changing audio envelope of an audio signal. By utilizing the dynamically supplied rail voltage, the power stage 108 amplifies audio signals received from the processing unit 112 and transmits amplified audio signals to speakers 104.

The tracking power supply 110 is configured to provide a dynamically adjustable rail voltage to the power stage 108 in the audio system 100. In operation, the tracking power supply 110 determines how much voltage is needed at any given time based on the time-varying amplitude of the audio signal received from the processing unit 112, thereby preventing the amplifier from operating at unnecessarily high voltages. By supplying an appropriate rail voltage that matches the real-time audio envelope, the tracking power supply 110 minimizes power consumption in the system 100.

In some embodiments, the tracking power supply 110 is further configured to use output voltage limits to maintain reliable operation within the constraints of the power stage 108 and tracking power supply 110 hardware topology. The minimum and maximum voltage limits define an operating range for the tracking power supply 110 and prevent voltage levels that could lead to instability or hardware damage. The minimum output voltage limit is selected based on both the lowest voltage that the tracking power supply 110 can generate and the minimum voltage required for stable operation of the power stage 108. For example, if tracking power supply 110 can generate a minimum voltage of 0.0V, but the power stage 108 requires at least 5.0V for proper operation, the minimum voltage is configured slightly higher, such as 6.0V, to account for worst-case transients or fluctuations. Similarly, the maximum output voltage limit is defined based on the highest voltage that the tracking power supply 110 can generate and the voltage tolerance of the power stage 108. For example, if the tracking power supply 110 has a maximum voltage of 36.0V, while the power stage 108 can operate up to 42.0V, the maximum voltage limit is set to 36.0V to maintain safe operation and prevent overvoltage conditions.

The computing device 118 is a dedicated processing module within the amplifier 106. The computing device 118 includes a processing unit 112, which can be any suitable processor, such as a central processing unit (CPU), a graphics processing unit (GPU), an application-specific integrated circuit (ASIC), a field programmable gate array (FPGA), a digital signal processor (DSP), and/or any other type of processing unit, including combinations thereof, such as a CPU configured to operate in conjunction with a GPU. In general, the processing unit 112 can be any technically feasible hardware unit capable of processing data and/or executing software applications.

The processing unit 112 executes the tracking power supply control 116 to generate a tracking power supply control signal, which specifies a target voltage level for the tracking power supply 110. The processing unit 112 can be embodied as a microcontroller, a digital signal processor (DSP), or any other suitable processing device. The tracking power supply control signal is transmitted to the tracking power supply 110, which dynamically adjusts the rail voltage supplied to the power stage 108 based on the computed target voltage level.

The memory 114 can include a random-access memory (RAM) module, a flash memory unit, or any other type of memory unit or combination thereof. The processing unit 112 is configured to read data from and write data to the memory 114. In various embodiments, the memory 114 includes non-volatile memory, such as optical drives, magnetic drives, flash drives, or other storage. In some embodiments, separate data stores, such as an external data stores included in a network ("cloud storage") can supplement the memory 114. The tracking power supply control 116 within the memory 114 can be executed by the processing unit 112 to implement the overall functionality of the computing device 118 and, thus, to coordinate the operation of the amplifier 106 as a whole. In various embodiments, an interconnect bus (not shown) connects the processing unit 112, the memory 114 and any other components of the computing device 118.

The tracking power supply control 116 is a software or firmware component stored in the memory 114 and executed by the processing unit 112 to regulate the rail voltage for the power stage 108. By analyzing the incoming audio signal and identifying peaks and/or envelope of audio signal, the tracking power supply control 116 instructs the tracking power supply 110 to provide the necessary voltage level.

The tracking power supply control 116 determines the target voltage level for the power stage 108 by computing an absolute maximum sample value across one or more audio channels. In configurations supporting multiple channels, the tracking power supply control 116 identifies the absolute maximum sample value so that the resulting rail voltage includes the peak demands of the highest peak.

When the tracking power supply 110 supplies voltage to multiple power stages 108, the tracking power supply control 116 first determines the absolute maximum audio sample value across all channels. The total number of channels is the product of the number of power stages 108 and the number of channels in each power stage 108. The absolute maximum sample value is computed because audio signals can have positive and negative values. For example, in a four-channel configuration where two power stages have two channels, the tracking power supply control 116 determines the absolute highest amplitude sample among all four channels.

The tracking power supply 110 provides a positive rail voltage, V_{TPS}, which the power stage 108 utilizes to generate an amplified output that swings from +V_{TPS} to -V_{TPS}. The absolute maximum sample value ensures that the rail voltage is sufficient to generate peak audio signals across all channels. The absolute maximum sample value is then processed within the envelope-tracking technique executed by the tracking power supply control 116, allowing the tracking power supply 110 to dynamically adjust the rail voltage based on audio signal amplitude variations.

In some embodiments, the tracking power supply control 116 executes an envelope-tracking technique to dynamically adjust the rail voltage in response to changes in audio signal amplitude. The envelope-tracking technique monitors peak levels of the audio signal, assigning a current peak and a next peak to regulate rail voltage transitions efficiently. The current peak represents the highest detected amplitude within a predefined tracking window and determines the present rail voltage level. The next peak represents the next-highest amplitude detected within the tracking window and is used to transition voltage levels when the current peak expires. The tracking power supply control 116 updates the current peak whenever the incoming audio amplitude exceeds the previous current peak. In response, a hold timer resets, and the tracking power supply 110 increases the rail voltage accordingly. The hold timer defines the duration for which the current peak is maintained before transitioning to the next peak.

The tracking power supply control 116 further employs a peak hold that determines the duration in which the current peak is held before transitioning to the next peak. The tracking power supply control 116 tracks a peak hold count, which represents the real-time count of consecutive samples for which the tracking power supply control 116 maintains the current peak. The peak hold count is compared against a peak hold count limit, which defines the maximum number of consecutive samples that the current peak can be maintained before transitioning to the next peak. When the peak hold count remains below the peak hold count limit, the tracking power supply control 116 continues updating the current peak with higher amplitude samples, indicating that the hold time has not yet elapsed, such as in the beginning of an audio signal. Conversely, when the peak hold count reaches the peak hold count limit, the hold time has elapsed, and the tracking power supply control 116 updates the current peak to the next peak, which indicates a decrease in audio amplitude or the end of an audio signal. The tracking power supply control 116 prevents excessive or rapid fluctuations in power rail voltage and improves power efficiency.

The amplifier 106 introduces delay in the audio path to synchronize voltage rail adjustments with the amplified audio signal transmitted to the speakers 104 by delaying the audio signal. Accordingly, the tracking power supply control 116 applies a delay to the audio signal before transmitting the audio signal to the power stage 108, allowing the tracking power supply 110 to adjust the voltage rail to the appropriate level before amplification. The delay period, or audio delay time, is determined based on the transition time required for the tracking power supply 110 to reach a target voltage level. The delay technique mitigates under-voltage conditions, enabling the amplifier 106 to receive adequate power for driving the speakers 104 without distortion. By performing real-time rail voltage adjustments, the power stage 108 operates with minimal excess power consumption. The tracking power supply 110 regulates the voltage supplied to the power stage 108 in response to variations in the audio envelope, which optimizes power efficiency. Upon receiving the dynamically adjusted voltage from the tracking power supply 110, the power stage 108 amplifies the delayed and processed audio signal before transmitting to the speakers 104.

In some embodiments, to provide a delay in the audio path signal, the tracking power supply control 116, executed by the processing unit 112, evaluates the incoming audio signal in real time to identify a current peak and/or a next peak, each associated with a peak hold interval. When a subsequent audio signal sample exceeds the current peak, the hold timer resets, and the tracking power supply 110 is instructed to raise the rail voltage accordingly. Conversely, if no audio signal sample exceeds the current peak during the hold interval, the tracking power supply control 116 transitions to the next peak value, thereby avoiding abrupt voltage changes. By applying a delay to the audio signal before reaching the power stage 108, the amplifier 106 provides the tracking power supply 110 sufficient time to achieve the target voltage level for the peaks. Once the rail voltage is adjusted to match the envelope of the delayed audio signal, the power stage 108 amplifies the audio signal and transmits the amplified audio signal to the speakers 104.

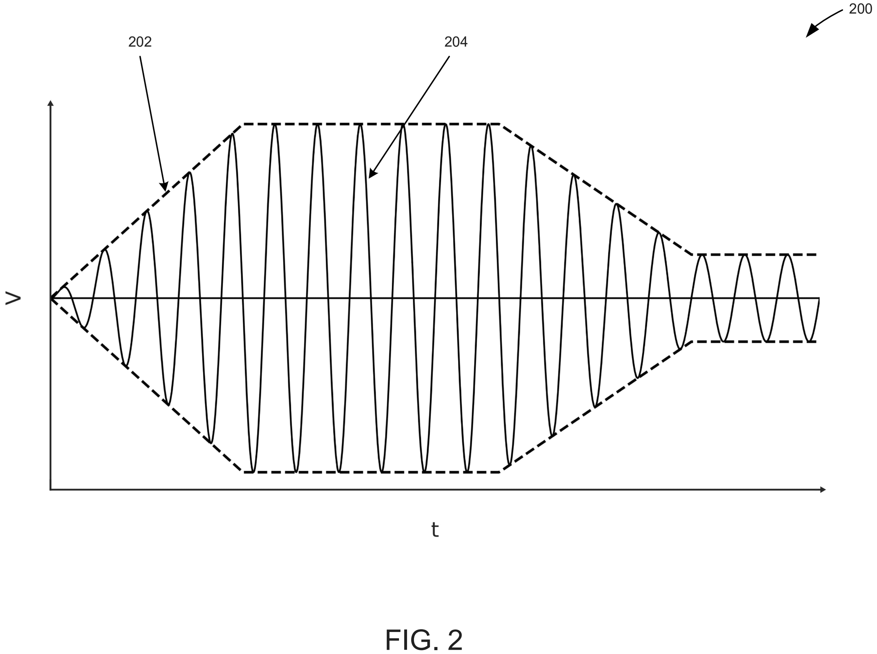

Figure 2 illustrates a diagram 200 of an example audio waveform in accordance with some embodiments. As shown in Figure 2, the diagram 200 includes an example of an envelope 202 and an audio signal 204, both plotted over time. In certain implementations, the tracking power supply control 116 within the amplifier 106 analyzes the audio signal 204 to identify the amplitude profile captured by the envelope 202. By determining an absolute maximum audio sample value prior to the envelope computation, the tracking power supply control 116 enables the tracking power supply 110 to provide sufficient rail voltage to accommodate the highest detected amplitude.

In some embodiments, the tracking power supply control 116 computes an absolute maximum audio sample value across one or more channels prior to performing envelope tracking. For example, when multiple channels share a single power stage 108, determining the absolute maximum audio sample value enables the power stage 108 to provide a rail voltage matched to the highest amplitude peak, thereby preventing under-voltage amplification on each channel. Determining the highest amplitude sample in advance prevents the power stage 108 from oversizing the rail voltage for each channel, which can improve overall power efficiency.

In further embodiments, the tracking power supply control 116 instructs the tracking power supply 110 to adjust the rail voltage based on the envelope 202 of the audio signal 204. Whenever the tracking power supply control 116 detects a higher peak, the absolute maximum audio sample value increases, prompting a new rail voltage target. Conversely, when the highest amplitude peak declines, the tracking power supply control 116 instructs the tracking power supply 110 to lower the rail voltage, thereby conserving power. By analyzing the envelope 202 of the audio signal 204, the amplifier 106 minimizes distortion and clipping that can occur if insufficient rail voltage were available for an audio peak. In addition, the amplifier 106 avoids operating continuously at a higher voltage than required by the audio signal 204.

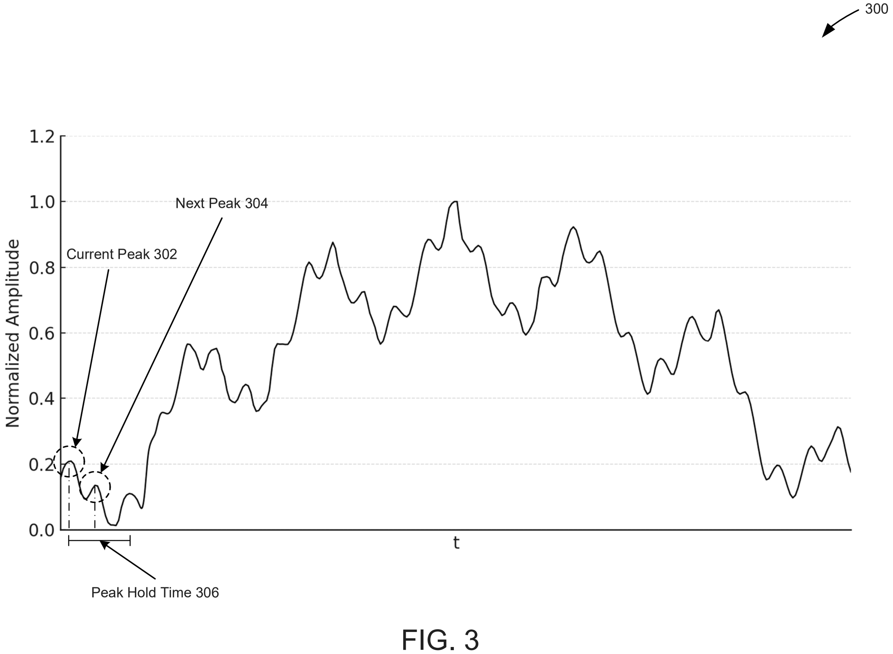

Figure 3 illustrates a diagram 300 of an example audio waveform illustrating the envelope-tracking technique utilized by tracking power supply control 116 to generate a tracking power supply control signal. As shown, the diagram 300 shows normalized audio signal amplitude versus time and illustrates a current peak 302, a next peak 304, and a peak hold time 306. In operation, the envelope-tracking technique begins by processing a new audio signal sample or set of samples received from head unit 102 at a certain sample rate (e.g., 48 KHz or 96 KHz) to identify the current peak 302 and the next peak 304. The current peak 302 and the next peak 304 are the highest amplitude and second-highest amplitude, respectively, that tracking power supply control 116 identifies and records within the time window defined by peak hold time 306. The peak hold time 306 is a time interval stored in memory 114 during which the tracking power supply control 116 identifies and records the current peak 302 and the next peak 304. The peak hold time 306 can be specified during calibration of the tracking power supply control 116.

When a new audio signal sample exceeds the current peak 302 value before the peak hold time 306 elapses, the tracking power supply control 116 resets peak hold time 306 and updates the current peak 302 to the new audio signal sample value. Conversely, as shown in Figure 3, when a new audio signal sample does not exceed the current peak 302 and the next peak 304 within the peak hold time 306, the tracking power supply control 116 locks in the current peak 302 and the next peak 304 values. If the new audio signal sample remains below the current peak 302 but exceeds the next peak 304, the tracking power supply control 116 locks in the current peak 302 and updates the next peak 304 to the new audio signal sample value.

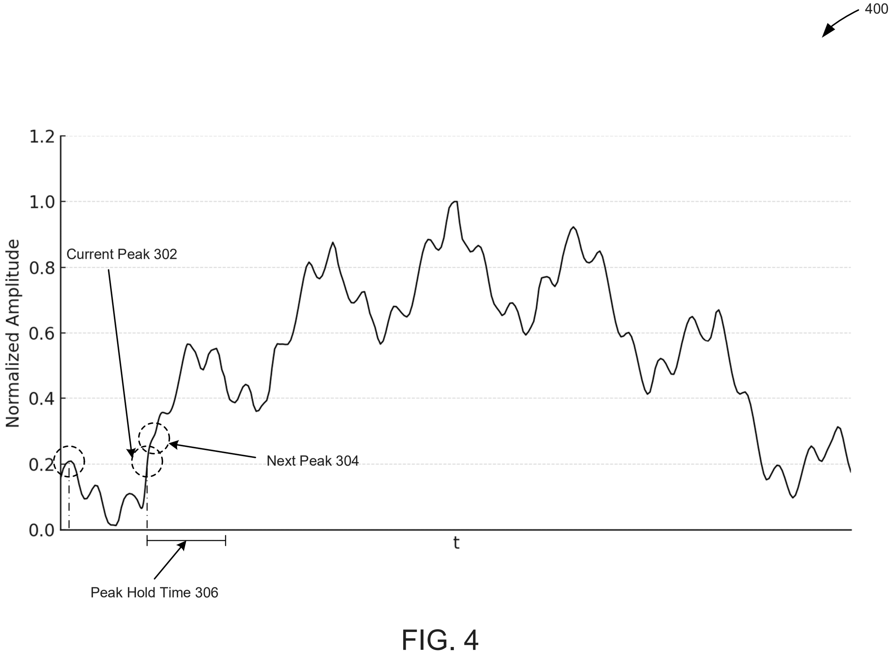

Figure 4 illustrates a diagram 400 of an example audio waveform illustrating the envelope-tracking technique utilized by tracking power supply control 116 to generate a tracking power supply control signal. The example in Figure 4 continues the example of Figure 3. As shown, when a new audio sample value surpasses or equals the current peak 302, the tracking power supply control 116 resets the peak hold time 306 and sets the current peak 302 to the new detected audio signal sample value. In addition, the next peak 304 is set to zero, allowing the tracking power supply control 116 to initiate a new search for the next peak 304 in the subsequent audio samples.

As illustrated in Figure 4, each time the amplitude of a new audio signal sample meets or exceeds the current peak 302, the peak hold time 306 restarts, and the current peak 302 becomes the highest measured amplitude of new audio signal sample. If the amplitude of the audio signal continues to increase within peak hold time 306, the tracking power supply control 116 repeats updating the current peak 302 to reflect the new higher amplitude. Simultaneously, the tracking power supply control 116 resets the next peak 304, and discards any recorded second-highest amplitude. By continually resetting the peak hold time 306 and next peak 304 value in response to rising audio levels, the diagram 400 shows how the envelope-tracking technique updates current peak 302 and ensures adequate voltage for the most recent audio signal amplitude.

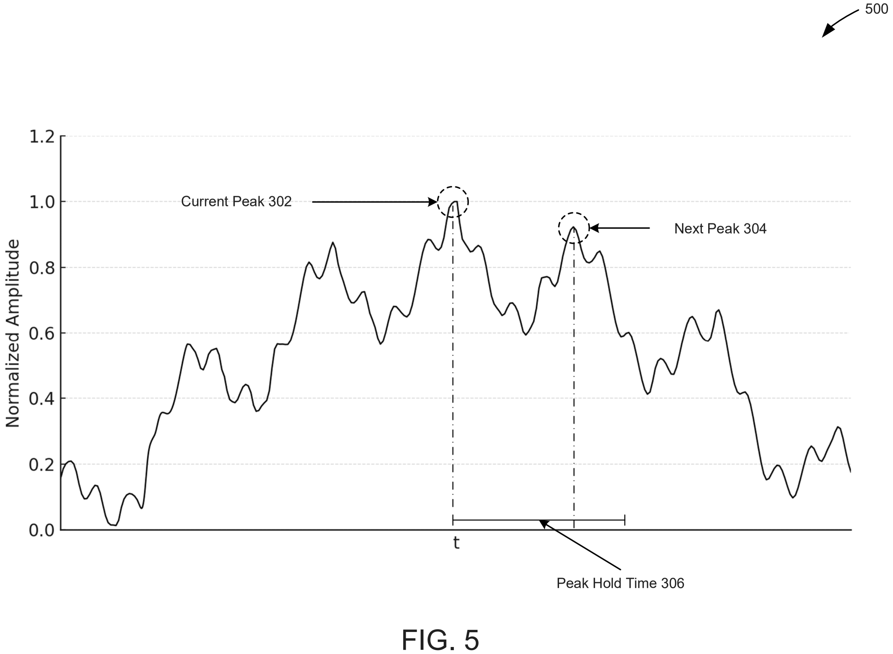

Figure 5 illustrates a diagram 500 of an example audio waveform illustrating the envelope-tracking technique utilized by tracking power supply control 116 to generate a tracking power supply control signal. The example in Figure 5 continues the example of Figure 3-4. As shown, the tracking power supply control 116 steps down the current peak 302 after the new audio signal sample remains below the current peak 302 for longer than the peak hold time 306. The tracking power supply control 116 records the highest overall peak in the audio waveform as the current peak 302 and searches for the next peak 304 that appears during peak hold time 306.

According to some embodiments, as the amplitude of the audio signal continues to drop below the current peak 302 for a duration exceeding peak hold time 306, the tracking power supply control 116 determines that no higher amplitude has been detected. Consequently, the tracking power supply control 116 assigns the next peak 304 to the current peak 302 and resets both the peak hold time 306 and the next peak 304 values.

The tracking power supply control 116 repeatedly assigns the next peak 304 to the current peak 302 until the audio signal reaches a value below the configured minimum rail voltage threshold or until the audio signal begins ramping upward. Under conditions where the audio signal remains relatively low, the tracking power supply 110 continues lowering the rail voltage, thereby conserving power. When the audio signal rises above the newly assigned current peak 302, the tracking power supply control 116 resets the peak hold time 306, and the tracking power supply 110 increases the rail voltage accordingly.

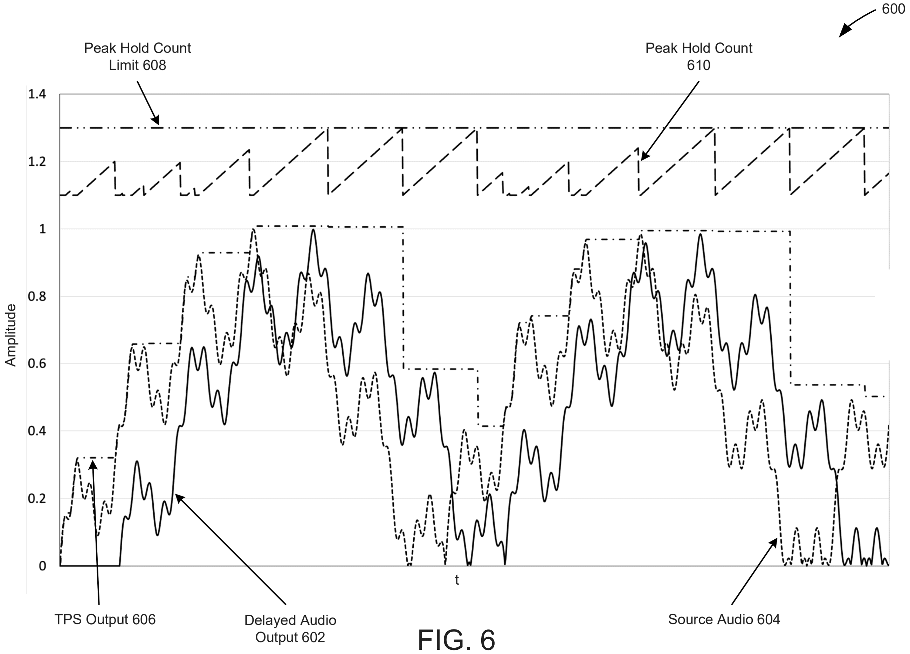

Figure 6 illustrates a diagram 600 of an example envelope-tracking implementation for an audio waveform. As shown, diagram 600 includes a delayed audio output 602 overlaid with the original source audio 604, along with a TPS output 606 representing the rail voltage requested by the tracking power supply control 116. The plot further shows a peak hold count limit 608 and a peak hold count 610.

As illustrated in Figure 6, the delayed audio output 602, which is the source audio 604 delayed by a predefined time duration, enables the power stage 108 to receive adequate rail voltage from the tracking power supply 110. As the tracking power supply control 116 processes incoming audio signal samples from the head unit 102, the tracking power supply control 116 requests a TPS output 606 that increases or decreases based on the next peak 304 and the duration of the peak hold time 306. TPS output 606 increases or decreases in proportion to changes in the original source audio 604. Because the tracking power supply 110 has slewing limitations, the actual rail voltage may not precisely match the requested TPS output 606 but remains sufficiently close to prevent under-voltage or distortion. Additionally, an output headroom value is added to the calculated TPS voltage to ensure that the rail voltage exceeds the amplitude of the audio signal. The headroom value is configured as a non-negative parameter.

In some embodiments, the processing unit 112 applies a hardware-dependent delay to the source audio 604 signal to generate delayed audio output 602. The applied delay allows the tracking power supply 110 sufficient time to ramp the rail voltage upwards or downwards. The peak hold delay is configured to account for the hardware-dependent delay such that the TPS output 606 remains at the required level to maintain a sufficient real voltage until the delayed audio output 602 reaches the power stage 108.

As further shown in Figure 6, diagram 600 shows the peak hold count limit 608 and the peak hold count 610 to illustrate the process by which the tracking power supply control 116 transitions between peaks. The peak hold count 610 represents the real-time count of samples that the tracking power supply control 116 has maintained as the current peak 302. The peak hold count limit 608 represents the maximum number of consecutive samples that the current peak 302 is held before transitioning to the next peak 304. When a higher amplitude sample is detected, the tracking power supply control 116 resets the peak hold count 610 to zero and updates the current peak 302 indicating the start of a new audio signal or an increasing audio signal amplitude. When a higher amplitude sample is not detected, the peak hold count 610 increases. For the period in which the peak hold count 610 remains below the peak hold count limit 608, the tracking power supply control 116 maintains the current peak 302, meaning the peak hold time 306 has not yet elapsed. Conversely, when the peak hold count 610 reaches the peak hold count limit 608, the peak hold time 306 has elapsed. The tracking power supply control 116 updates the current peak 302 to the next peak 304, which indicates the end of an audio signal or a decreasing audio signal amplitude.

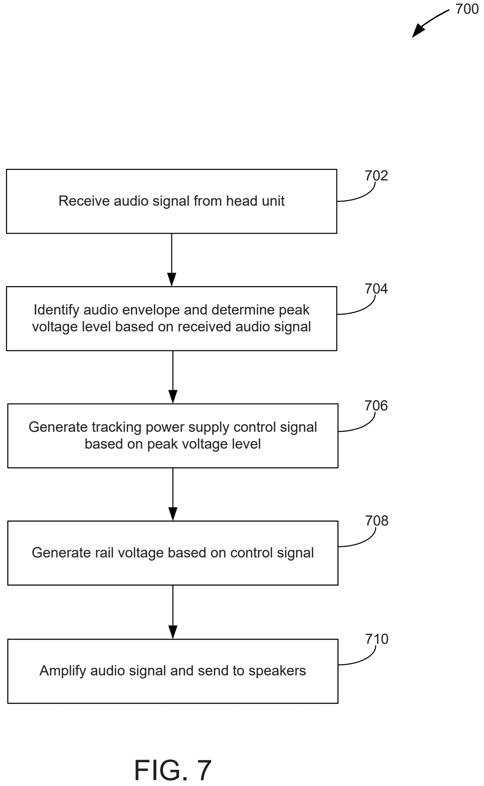

Figure 7 illustrates a flow diagram of method steps for generating a rail voltage based on tracking power supply control signal in an audio amplification system, according to various embodiments. Although the method steps are described with reference to the embodiments of Figures 1-6, persons skilled in the art will understand that any system configured to implement the method steps, in any order, falls within the scope of the present disclosure.

Method 700 begins at step 702, where the processing unit 112 receives an audio signal from the head unit 102. The audio signal represents the time-domain representation of sound data to be processed and amplified within the amplifier 106. The received audio signal can include a multi-channel digital audio signal, with each channel corresponding to a separate output path.

At step 704, the computing device 118 analyzes the received audio signal to identify the audio envelope and determine a peak voltage level for a given time period. The envelope of the audio signal represents the time-dependent variation in amplitude, which determines the voltage requirements for proper amplification. The tracking power supply control 116, executed by the processing unit 112, computes an absolute maximum sample value across one or more channels to determine the peak voltage level. In configurations where multiple power stages 108 exist, each with multiple channels, the tracking power supply control 116 determines the total number of channels by multiplying the number of power stages 108 by the number of channels per power stage 108. The absolute maximum sample value is computed to include both positive and negative audio signal values.

At step 706, the tracking power supply control 116 generates a tracking power supply control signal based on the peak voltage level determined in step 704. The tracking power supply control signal specifies the voltage level required for the tracking power supply 110 to supply an appropriate rail voltage to the power stage 108. The tracking power supply control 116 applies an envelope-tracking technique that monitors changes in audio signal amplitude and dynamically adjusts the control signal. The algorithm maintains a current peak and a next peak, with the current peak representing the highest detected amplitude in each tracking sample and the next peak representing the next-highest amplitude that determines the subsequent rail voltage adjustment.

The tracking power supply control 116 updates the current peak 302 whenever an incoming audio signal sample exceeds the previously stored current peak 302 before the peak hold time 306 elapses. Upon updating the current peak 302, the peak hold time 306 resets, and the tracking power supply 110 searches for a new next peak 304 and increases the rail voltage accordingly. If a new audio signal sample does not exceed the current peak 302 but surpasses the next peak 304, the tracking power supply control 116 updates the next peak 304 to the new audio signal sample value while maintaining the current peak 302. If the new sample is lower than both the current peak 302 and the next peak 304, no update occurs until peak hold time 306 elapses, and the current peak 302 and next peak 304 remain locked. In other words, the current peak 302 remains unchanged until the peak hold time 306 has elapsed.

When the peak hold time 306 elapses without a new audio signal sample exceeding the current peak 302, the tracking power supply control 116 assigns the next peak 304 to the current peak 302 and resets the peak hold time 306 and the next peak 304 values. The envelope-tracking technique continues, identifying and storing the highest and second-highest amplitudes within the next peak hold time 306 interval. If the audio signal amplitude remains below the current peak 302 for a duration exceeding the peak hold time 306, the tracking power supply control 116 steps down the current peak 302 to the next peak 304, allowing the rail voltage to decrease.

The tracking power supply control 116 further employs a peak hold count, which tracks the number of consecutive samples during which the current peak is maintained. The peak hold count limit defines the maximum number of consecutive samples that the current peak can be held before transitioning to the next peak. When a higher amplitude sample is detected, the tracking power supply control 116 resets the peak hold count 610 to zero and updates the current peak 302 indicating the start of a new audio signal or an increasing audio signal amplitude. When a higher amplitude sample is not detected, the peak hold count 610 increases. For the period in which the peak hold count 610 remains below the peak hold count limit 608, the tracking power supply control 116 maintains the current peak 302, meaning the peak hold time 306 has not yet elapsed. Conversely, when the peak hold count reaches the peak hold count limit, the peak hold time 306 has elapsed, the tracking power supply control 116 updates the current peak 302 to the next peak 304, which corresponds to a decrease in audio signal amplitude or the end of an audio signal.

In some embodiments, the processing unit 112 applies a hardware-dependent delay to the audio signal to generate delayed audio signal. The applied delay allows the tracking power supply 110 sufficient time to ramp the rail voltage upwards or downwards.

At step 708, the tracking power supply 110 generates a dynamically adjustable rail voltage based on the tracking power supply control signal received from the tracking power supply control 116. The tracking power supply 110 continuously monitors and adjusts the rail voltage in real time to minimize power dissipation while providing sufficient headroom for peak signal amplitudes. The tracking power supply 110 generates the rail voltage within predefined output voltage limits. The minimum voltage is set to ensure that the power stage 108 remains operational and does not enter an under-voltage condition, while the maximum voltage is constrained by the hardware capabilities of the power stage 108 and/or the tracking power supply 110. The predefined output voltage limits prevent instability, voltage overshoot, and potential damage to the components.

The tracking power supply 110 provides a rail voltage, V_{TPS}, in which the power stage 108 utilizes to generate an amplified output that swings between +V_{TPS} and -V_{TPS}. By dynamically adjusting V_{TPS} in response to the control signal received from the tracking power supply control 116, the tracking power supply 110 generates rail voltage accordingly.

At step 710, the power stage 108 amplifies the audio signal and transmits the amplified signal to the speakers 104. The tracking power supply 110 dynamically provides the necessary rail voltage for efficient power usage. The power stage 108 receives the delayed audio output from processing unit 112, along with corresponding rail voltage from the tracking power supply 110. By utilizing the dynamically adjusted rail voltage, the power stage 108 prevents excessive power dissipation and reduces distortion in the amplified audio signal. The amplified signal is then delivered to the speakers 104, which convert the electrical signal into audible sound.

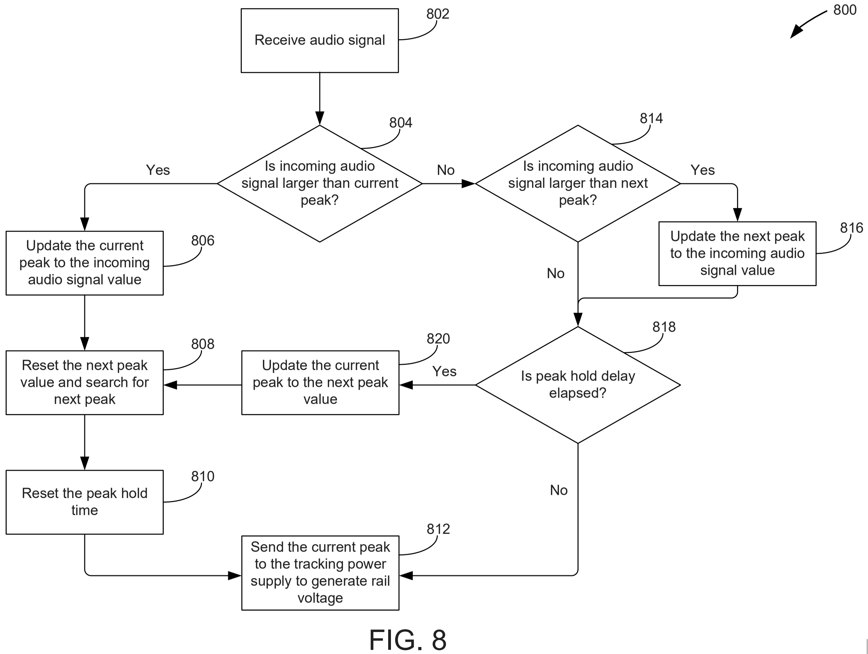

Figure 8 illustrates a flow diagram of method steps 800 for generating a tracking power supply control signal based on a peak voltage level, according to various embodiments. Although the method steps are described with reference to the embodiments of Figures 1-6, persons skilled in the art will understand that any system configured to implement the method steps, in any order, falls within the scope of the present disclosure.

Method 800 begins at step 802, where the tracking power supply control 116 receives an incoming audio signal from head unit 102. The audio signal represents time-domain sound data to be processed within the amplifier 106 and can include a multi-channel audio signal.

At step 804, the tracking power supply control 116 determines whether a voltage level associated with the incoming audio signal is larger than a previously stored current peak 302. If the tracking power supply control 116 determines that a voltage level associated with the incoming audio signal is larger than the current peak 302, method 800 proceeds to step 806. If the voltage level the incoming audio signal is not larger than the current peak 302, method 800 proceeds to step 814.

At step 806, the tracking power supply control 116 updates the current peak 302 to the value of the incoming audio signal. By updating the current peak 302 to the highest observed amplitude before the peak hold time 306 elapses, the tracking power supply control 116 provides sufficient rail voltage for the current peak 302. At step 806, the peak hold count, which tracks the number of consecutive samples during which the current peak is maintained, resets.

At step 808, the tracking power supply control 116 resets the next peak 304, thereby discarding any second-highest amplitude that was previously stored. In addition, a new search for the next peak 304 begins to capture any subsequent amplitude that does not exceed the current peak 302.

At step 810, the tracking power supply control 116 resets the peak hold time 306, allowing the tracking power supply control 116 to maintain the new current peak 302 for a duration of peak hold time 306 or until a higher amplitude audio signal is detected. Resetting the peak hold time 306 prevents the rail voltage from changing too frequently while providing sufficient rail voltage for high amplitude audio signals.

At step 812, the tracking power supply control 116 sends the updated current peak 302 to the tracking power supply 110, which generates a corresponding rail voltage for the power stage 108 to amplify the audio signal. By dynamically matching the rail voltage to the amplitude defined by the current peak 302, the tracking power supply 110 minimizes power consumption and maintains sufficient voltage headroom to prevent signal distortion.

At step 814, the tracking power supply control 116 determines whether a voltage level of the incoming audio signal is larger than the next peak 304. In operation, if an incoming sample does not exceed the current peak 302 but surpasses the next peak 304, the tracking power supply control 116 updates only the next peak 304 at step 816. Meanwhile, the current peak 302 remains locked until the peak hold time 306 elapses.

If the incoming audio signal is not greater than the current peak 302 and the next peak 304, method 800 proceeds from step 814 to step 818. At step 818, the tracking power supply control 116 determines whether the peak hold time 306 has elapsed. If the peak hold time 306 has not elapsed, method 800 proceeds to step 812. At step 812, tracking power supply control 116 sends the unchanged current peak 302 to the tracking power supply 110. If the peak hold time 306 has elapsed, method 800 proceeds from step 818 to step 820, where tracking power supply control 116 assigns the next peak 304 to the current peak 302. After completing step 820, method 800 proceeds to step 808, resetting the next peak 304 and searches for new peak values. Then at step 810, the tracking power supply control 116 resets the peak hold time 306. Finally, at step 812, the tracking power supply control 116 sends the updated current peak 302 to the tracking power supply 110, thereby lowering the rail voltage as needed while preserving headroom for amplitude fluctuations.

In sum, the disclosed techniques dynamically manage power in audio systems within amplifiers. The disclosed techniques process digital or analog audio signals, identifies a signal envelope, calculates the required TPS voltage for the audio signal in real time, and adjusts the TPS voltage rail accordingly. Additionally, by synchronizing an input audio signal with TPS voltage adjustments to provide efficient amplification while minimizing energy waste. The disclosed techniques are implemented within amplifiers of an audio system, eliminating the need for an HPC such as the head unit of the audio system to perform envelope tracking or manage voltage requirements for downstream amplifiers. This approach simplifies integration, reduces system complexity, and enhances the efficiency of automotive and other audio systems.

At least one technical advantage of the disclosed techniques relative to the prior art is that, with the disclosed techniques, TPS control can be integrated into one or more amplifiers of an audio system, rather than relying on separate HPC. By implementing TPS control within one or more of the amplifiers of an audio system, the amplifiers can dynamically adjust voltage rails utilized by the system to increase power efficiency in real time resulting in lower overall energy consumption compared to prior art approaches. Additionally, by implementing TPS control within the amplifiers, the disclosed techniques enable the amplifiers to dynamically adjust voltage rails based solely on the incoming digital audio signal, which removes the need to configure the head unit or HPC with detailed information about downstream voltage requirements. As a result, reducing computational demands and the amplification becomes computationally efficient. These technical advantages provide one or more technological improvements over prior art approaches.
1. In some embodiments, a computer-implemented method for powering one or more audio output devices comprises receiving, by a processing unit within an amplifier, an audio signal from a head unit, identifying, by the processing unit, an audio envelope associated with the audio signal, determining, by the processing unit, a first peak voltage level associated with a first time period based on the audio envelope, determining, by the processing unit, a tracking power supply control signal based on the first peak voltage level associated with the first time period, and specifying, by the processing unit, a rail voltage of the amplifier based on the tracking power supply control signal.
2. The computer-implemented method of clause 1, further comprising determining, by the processing unit, a second peak voltage level associated with a second time period subsequent to the first time period based on the audio envelope, and adjusting, by the processing unit, the tracking power supply control signal based on the second peak voltage level associated with the second time period in response to determining that the second peak voltage level is greater than the first peak voltage level.
3. The computer-implemented method of clauses 1 or 2, further comprising determining, by the processing unit, a second peak voltage level associated with a second time period subsequent to the first time period based on the audio envelope, wherein the second peak voltage level is lower than the first peak voltage level, and adjusting, by the processing unit, the tracking power supply control signal based on the second peak voltage level associated with the second time period, wherein the second time period is subsequent to the first time period after a peak hold time has elapsed.
4. The computer-implemented method of any of clauses 1-3, further comprising resetting the peak hold time in response to adjusting the tracking power supply control signal based on the second peak voltage level associated with the second time period.
5. The computer-implemented method of any of clauses 1-4, further comprising determining, by the processing unit, a second peak voltage level during the first time period based on the audio envelope, wherein the second peak voltage level is lower than the first peak voltage level, and leaving, by the processing unit, the tracking power supply control signal unchanged based on the second peak voltage level in response to determining that a peak hold time from the first time period has not elapsed.
6. The computer-implemented method of any of clauses 1-5, wherein specifying the rail voltage based on the tracking power supply control signal comprises summing the first peak voltage level with a headroom value.
7. The method of any of clauses 1-6, wherein determining the first peak voltage level associated with the first time period further comprises delaying, by the processing unit, the audio signal in a memory of the amplifier by an audio delay time to generate a first delayed audio signal, wherein the audio delay time is based on a ramp-up time period associated with the amplifier.
8. The method of any of clauses 1-7, further comprising generating, by the processing unit, an audio output signal based on the first delayed audio signal and the rail voltage of the amplifier.
9. The method of any of clauses 1-8, further comprising outputting, by the processing unit, the audio output signal to at least one speaker.
10. In some embodiments, one or more non-transitory computer-readable media store instructions that, when executed by one or more processors of an amplifier, cause the one or more processors to perform the steps of receiving an audio signal from a head unit, identifying an audio envelope associated with the audio signal, determining a first peak voltage level associated with a first time period based on the audio envelope, determining a tracking power supply control signal based on the first peak voltage level associated with the first time period, and specifying a rail voltage of the amplifier based on the tracking power supply control signal.
11. The one or more non-transitory computer-readable media of clause 10, wherein the audio signal comprises a multi-channel digital audio signal corresponding to an audio source being played back by the head unit.
12. The one or more non-transitory computer-readable media of clauses 10 or 11, the steps further comprising generating an amplified audio output signal based on the rail voltage of the amplifier and the audio signal.
13. The one or more non-transitory computer-readable media of any of clauses 10-12, the steps further comprising outputting the amplified audio output signal to at least one speaker.
14. The one or more non-transitory computer-readable media of any of clauses 10-13, the steps further comprising determining a second peak voltage level associated with a second time period subsequent to the first time period based on the audio envelope, and adjusting the tracking power supply control signal based on the second peak voltage level associated with the second time period in response to determining that the second peak voltage level is greater than the first peak voltage level.
15. The one or more non-transitory computer-readable media of any of clauses 10-14, the steps further comprising determining a second peak voltage level associated with a second time period subsequent to the first time period based on the audio envelope, wherein the second peak voltage level is lower than the first peak voltage level, and adjusting the tracking power supply control signal based on the second peak voltage level associated with the second time period, wherein the second time period is subsequent to the first time period after a peak hold time has elapsed.
16. The one or more non-transitory computer-readable media of any of clauses 10-15, the steps further comprising resetting the peak hold time in response to adjusting the tracking power supply control signal based on the second peak voltage level associated with the second time period.
17. The one or more non-transitory computer-readable media of any of clauses 10-16, the steps further comprising determining a second peak voltage level during the first time period based on the audio envelope, wherein the second peak voltage level is lower than the first peak voltage level, and leaving the tracking power supply control signal unchanged based on the second peak voltage level in response to determining that a peak hold time from the first time period has not elapsed.
18. The one or more non-transitory computer-readable media of any of clauses 10-17, wherein specifying the rail voltage based on the tracking power supply control signal comprises summing the first peak voltage level with a headroom value.
19. The one or more non-transitory computer-readable media of any of clauses 10-18, wherein determining the first peak voltage level associated with the first time period further comprises delaying the audio signal in a memory of the amplifier by an audio delay time to generate a first delayed audio signal, wherein the audio delay time is based on a ramp-up time period associated with the amplifier.
20. In some embodiments, a system comprises an amplifier circuit, a memory storing a tracking power supply control, and a processor coupled to the memory that executes the tracking power supply control by performing the steps of receiving an audio signal from a head unit, identifying an audio envelope associated with the audio signal, determining a first peak voltage level associated with a first time period based on the audio envelope, determining a tracking power supply control signal based on the first peak voltage level associated with the first time period, and specifying a rail voltage of the amplifier circuit based on the tracking power supply control signal.

Any and all combinations of any of the claim elements recited in any of the claims and/or any elements described in this application, in any fashion, fall within the contemplated scope of the present invention and protection.

The descriptions of the various embodiments have been presented for purposes of illustration, but are not intended to be exhaustive or limited to the embodiments disclosed. Many modifications and variations will be apparent to those of ordinary skill in the art without departing from the scope and spirit of the described embodiments.

Aspects of the present embodiments may be embodied as a system, method, or computer program product. Accordingly, aspects of the present disclosure may take the form of an entirely hardware embodiment, an entirely software embodiment (including firmware, resident software, micro-code, etc.) or an embodiment combining software and hardware aspects that may all generally be referred to herein as a "module," a "system," or a "computer." In addition, any hardware and/or software technique, process, function, component, engine, module, or system described in the present disclosure may be implemented as a circuit or set of circuits. Furthermore, aspects of the present disclosure may take the form of a computer program product embodied in one or more computer readable medium(s) having computer readable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain, or store a program for use by or in connection with an instruction execution system, apparatus, or device.

Aspects of the present disclosure are described above with reference to flowchart illustrations and/or block diagrams of methods, apparatus (systems) and computer program products according to embodiments of the disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine. The instructions, when executed via the processor of the computer or other programmable data processing apparatus, enable the implementation of the functions/acts specified in the flowchart and/or block diagram block or blocks. Such processors may be, without limitation, general purpose processors, special-purpose processors, application-specific processors, or field-programmable gate arrays.

The flowchart and block diagrams in the figures illustrate the architecture, functionality, and operation of possible implementations of systems, methods and computer program products according to various embodiments of the present disclosure. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

While the preceding is directed to embodiments of the present disclosure, other and further embodiments of the disclosure may be devised without departing from the basic scope thereof, and the scope thereof is determined by the claims that follow.

## Claims

1. A computer-implemented method for powering one or more audio output devices, the method comprising:
receiving, by a processing unit within an amplifier, an audio signal from a head unit;
identifying, by the processing unit, an audio envelope associated with the audio signal;
determining, by the processing unit, a first peak voltage level associated with a first time period based on the audio envelope;
determining, by the processing unit, a tracking power supply control signal based on the first peak voltage level associated with the first time period; and
specifying, by the processing unit, a rail voltage of the amplifier based on the tracking power supply control signal.

2. The computer-implemented method of claim 1, further comprising:
determining, by the processing unit, a second peak voltage level associated with a second time period subsequent to the first time period based on the audio envelope; and
adjusting, by the processing unit, the tracking power supply control signal based on the second peak voltage level associated with the second time period in response to determining that the second peak voltage level is greater than the first peak voltage level.

3. The computer-implemented method of claim 1 or 2, further comprising:
determining, by the processing unit, a second peak voltage level associated with a second time period subsequent to the first time period based on the audio envelope, wherein the second peak voltage level is lower than the first peak voltage level; and
adjusting, by the processing unit, the tracking power supply control signal based on the second peak voltage level associated with the second time period, wherein the second time period is subsequent to the first time period after a peak hold time has elapsed.

4. The computer-implemented method of any of claims 1 to 3, further comprising resetting the peak hold time in response to adjusting the tracking power supply control signal based on the second peak voltage level associated with the second time period.

5. The computer-implemented method of any of claims 1 to 4, further comprising:
determining, by the processing unit, a second peak voltage level during the first time period based on the audio envelope, wherein the second peak voltage level is lower than the first peak voltage level; and
leaving, by the processing unit, the tracking power supply control signal unchanged based on the second peak voltage level in response to determining that a peak hold time from the first time period has not elapsed.

6. The computer-implemented method of any of claims 1 to 5, wherein specifying the rail voltage based on the tracking power supply control signal comprises summing the first peak voltage level with a headroom value.

7. The computer-implemented method of any of claims 1 to 6, wherein determining the first peak voltage level associated with the first time period further comprises delaying, by the processing unit, the audio signal in a memory of the amplifier by an audio delay time to generate a first delayed audio signal, wherein the audio delay time is based on a ramp-up time period associated with the amplifier.

8. The computer-implemented method of any of claims 1 to 7, further comprising generating, by the processing unit, an audio output signal based on the first delayed audio signal and the rail voltage of the amplifier.

9. The computer-implemented method of any of claims 1 to 8, further comprising outputting, by the processing unit, the audio output signal to at least one speaker.

10. One or more non-transitory computer-readable media storing instructions that, when executed by one or more processors of an amplifier, cause the one or more processors to perform the steps of:
receiving an audio signal from a head unit;
identifying an audio envelope associated with the audio signal;
determining a first peak voltage level associated with a first time period based on the audio envelope;
determining a tracking power supply control signal based on the first peak voltage level associated with the first time period; and
specifying a rail voltage of the amplifier based on the tracking power supply control signal.

11. The one or more non-transitory computer-readable media of claim 10, wherein the audio signal comprises a multi-channel digital audio signal corresponding to an audio source being played back by the head unit.

12. The one or more non-transitory computer-readable media of claim 10 or 11, the steps further comprising generating an amplified audio output signal based on the rail voltage of the amplifier and the audio signal.

13. The one or more non-transitory computer-readable media of any of claims 10 to 12, the steps further comprising outputting the amplified audio output signal to at least one speaker.

14. The one or more non-transitory computer-readable media of any of claims 10 to 13, the steps further comprising:
determining a second peak voltage level associated with a second time period subsequent to the first time period based on the audio envelope; and
adjusting the tracking power supply control signal based on the second peak voltage level associated with the second time period in response to determining that the second peak voltage level is greater than the first peak voltage level.

15. A system comprising:
an amplifier circuit;
a memory storing a tracking power supply control; and
a processor coupled to the memory that executes the tracking power supply control by performing the steps of:
receiving an audio signal from a head unit;
identifying an audio envelope associated with the audio signal;
determining a first peak voltage level associated with a first time period based on the audio envelope;
determining a tracking power supply control signal based on the first peak voltage level associated with the first time period; and
specifying a rail voltage of the amplifier circuit based on the tracking power supply control signal.
